# EUROPEAN PATENT APPLICATION

(11) **EP 3 296 422 A1**
(43) Date of publication of application: **21.03.2018**
(21) Application number: 16792501.5
(22) Date of filing: 20.04.2016
(51) Int. Cl.: C23C 14/34, C23C 14/06, H01B 13/00

(54) **REACTIVE SPUTTERING METHOD AND LAMINATE FILM PRODUCTION METHOD**

(30) Priority: 13.05.2015 JP 2015098054
(71) Applicant: Sumitomo Metal Mining Co., Ltd., Tokyo 105-8716 (JP)
(72) Inventor: WATANABE, Hiroto, Niihama-shi Ehime 792-0008 (JP)
(74) Representative: TBK
(86) International application number: PCT/JP2016/062467
(87) International publication number: WO 2016/181776

(57) **Abstract**

Provided is a reactive sputtering method and the like that are capable of making it unlikely for a particle deposit deposited on a non-erosion region or a nodule generated in an erosion region to be peeled off from a sputtering target, and of suppressing arc discharge and the like.

A reactive sputtering method for performing deposition by using a sputtering device including magnetron sputtering cathodes 17, 18, 19, and 20 in a vacuum chamber 10, and by introducing a process gas containing a reactive gas into the vacuum chamber is wherein the reactive gas includes an oxygen gas or a nitrogen gas, and water is contained in the reactive gas. The action of water contained in the reactive gas makes it unlikely for a particle deposit and a nodule to be peeled off from a sputtering target, and also reduces the electric charges of the charged particle deposit or nodule, allowing arc discharge and the like to be suppressed.

## Description

### TECHNICAL FIELD

The present invention relates to a reactive sputtering method for performing deposition by introducing a process gas containing a reactive gas into a vacuum chamber, and particularly relates to a reactive sputtering method which makes it unlikely for a particle deposit deposited on a non-erosion region of a sputtering target and a nodule generated on an erosion region of the sputtering target to be peeled off from the sputtering target, and which is also capable of suppressing arc discharge and the like attributable to the charging of the above-described particle deposit and nodule, and to a method for producing a laminate film using the reactive sputtering method.

### BACKGROUND ART

In these days, "touch panels" have begun to spread, which are to be mounted in surfaces of flat panel displays (FPD) in portable phones, portable electronic document devices, automatic dispensers, car navigations systems, and the like.

The above-described "touch panels" are broadly categorized into a resistive touch panel and a capacitive touch panel. The "resistive touch panel" has a main portion including: a transparent substrate made of a resin film; an X-coordinate (or a Y-coordinate) detection electrode sheet and a Y-coordinate (or an X-coordinate) detection electrode sheet provided on the transparent substrate; and an insulator spacer provided between these sheets. The X-coordinate detection electrode sheet and the Y-coordinate detection electrode sheet are spatially apart from each other. When pressed by a pen or the like, these X- and Y-coordinate detection electrode sheets come into electrical contact with each other, indicating the position (the X-coordinate and the Y-coordinate) at which the pen has touched. Every time the pen is moved, the coordinates of the pen are continuously recognized, eventually making it possible to input a character. On the other hand, the "capacitive touch panel" has a structure in which an X-coordinate (or a Y-coordinate) detection electrode sheet and a Y-coordinate (or an X-coordinate)detection electrode sheet are laminated with an insulating sheet interposed in between, and an insulator made of glass or the like is disposed on these sheets. The capacitive touch panel thus has such a mechanism that when a finger is brought closer to the insulator made of glass or the like, the capacitances of the X-coordinate detection electrode and the Y-coordinate detection electrode near the finger change, allowing the position to be detected.

As a conductive material for forming a circuit pattern such as an electrode, transparent conductive films made of ITO (indium oxide-tin oxide) and the like have conventionally been widely used (see Patent Document 1). In addition, along with increases in sizes of touch panels, metal thin lines (metal films) having mesh structures, as disclosed in Patent Document 2, Patent Document 3, and other documents, have begun to be used.

Here, the transparent conductive film and the metal thin line (metal film) are compared. The transparent conductive film has an advantage that a circuit pattern such as an electrode is hardly visually recognized because of its excellent transparency in the visible wavelength region, but has a disadvantage that the transparent conductive film is unsuitable to increase the size or the response speed of a touch panel because of its higher electrical resistance value than that of the metal thin line (metal film). On the other hand, the metal thin line (metal film) is suitable to increase the size and the response speed of a touch panel because of its low electrical resistance value, but has a disadvantage of degrading the product value because a circuit pattern is sometimes visually recognized under highly bright illumination even when the metal thin line (metal film) is processed into a fine mesh structure due to its high reflectivity in the visible wavelength region.

In view of this, to make full use of the characteristics of the metal thin line (metal film) having a low electrical resistance value, a method has been proposed in which a metal absorption layer made of a metal oxide or a metal nitride is interposed between a transparent substrate made of a resin film and a metal thin line (metal film), thereby reducing the reflection from the metal thin line (metal film) observed from the transparent substrate side (see Patent Document 4 and Patent Document 5).

In addition, the above-described metal absorption layer made of a metal oxide or a metal nitride is formed by employing a method of continuously forming the metal absorption layer on a surface of a long resin film by a reactive sputtering method for performing deposition by using a sputtering device including a magnetron sputtering cathode to which a sputtering target is mounted, and by introducing a process gas (such as argon gas) containing a reactive gas such as an oxygen gas or a nitrogen gas into a vacuum chamber, from the viewpoint of improving the efficiency of forming a film of the metal oxide or the metal nitride.

### CONVENTIONAL ART DOCUMENTS

### PATENT DOCUMENTS

Patent Document 1: Japanese Patent Application Publication No. 2003-151358 (see claim 2)
Patent Document 2: Japanese Patent Application Publication No. 2011-018194 (see claim 1)
Patent Document 3: Japanese Patent Application Publication No. 2013-069261 (see paragraph 0004)
Patent Document 4: Japanese Patent Application Publication No. 2014-142462 (see claim 5 and paragraph 0038)
Patent Document 5: Japanese Patent Application Publication No. 2013-225276 (see claim 1 and paragraph 0041)

### SUMMARY OF THE INVENTION

### PROBLEM TO BE SOLVED BY THE INVENTION

Meanwhile it has been known that in a case where continuous formation of a metal absorption layer is performed by a reactive sputtering method using a sputtering device including a magnetron sputtering cathode to which a sputtering target is mounted, a compound formed by reaction of a reactive gas (an oxygen gas, a nitrogen gas, or the like) with a sputtering target material (a Ni alloy or the like) is deposited on a non-erosion region of the sputtering target as a particle deposit, and further a foreign matter called a nodule is generated at an end portion of an erosion region of the sputtering target.

Then, there are the following problems: if the above-described particle deposit or nodule is peeled off from the sputtering target and adheres to a deposition target or a deposition surface, this leads to a film defect (adhesion of a foreign matter). Further, if arc discharge or the like is generated due to charging of the particle deposit or the nodule, a dent is formed in the deposition surface, resulting in a film defect.

The present invention has been made in view of such problems, and an object thereof is to provide a reactive sputtering method capable of making it unlikely for a particle deposit deposited on a non-erosion region of a sputtering target and a nodule generated in an erosion region of the sputtering target to be peeled off from the sputtering target, and of suppressing arc discharge and the like attributable to the charging of the particle deposit and the nodule, and also to provide a method for producing a laminate film using the reactive sputtering method.

### MEANS FOR SOLVING THE PROBLEMS

To this end, the present inventors have diligently continued researches in order to solve the above-described problems, and attempted experiments of adding water to a sputtering deposition atmosphere in addition to a reactive gas such as an oxygen gas or a nitrogen gas. The present inventors have found that addition of water made the above-described particle deposit and nodule fixed to and unlikely to be peeled off from the sputtering target, and reduced the electric charges of the charged particle deposit and nodule owing to the electric conduction action of the water, thus suppressing arc discharge and the like. As a consequence, the present invention has been completed based on such technical finding.

Specifically, a first aspect of the present invention is
a reactive sputtering method for performing deposition by using a sputtering device including a magnetron sputtering cathode to which a sputtering target is mounted inside a vacuum chamber, and by introducing a process gas containing a reactive gas into the vacuum chamber, wherein
the reactive gas includes at least one of an oxygen gas and a nitrogen gas, and
water is contained in the reactive gas.

In addition, a second aspect of the invention is
the reactive sputtering method described in the first aspect, wherein
a proportion of water added in the process gas to be introduced into the vacuum chamber is 0.25 % by volume or more and 12.5 % by volume or less.

A third aspect of the invention is
the reactive sputtering method described in the first aspect, wherein
the sputtering target is made of Ni alone or a Ni-based alloy blended with one or more elements selected from Ti, Al, V, W, Ta, Si, Cr, Ag, Mo, and Cu.

Next, a fourth aspect of the present invention is
a method for producing a laminate film, the laminate film including: a transparent substrate made of a resin film; and a layered film provided on at least one surface of the transparent substrate, the layered film having a metal absorption layer, which is a first layer as counted from the transparent substrate side, and a metal layer, which is a second layer as counted from the transparent substrate side, wherein
the method comprising:
forming the metal absorption layer by using the reactive sputtering method described in the third aspect; and
forming the metal layer by using a sputtering device including a magnetron sputtering cathode to which a sputtering target is mounted inside a vacuum chamber, and by introducing a process gas containing no reactive gas into the vacuum chamber, the sputtering target made of Cu alone or a Cu-based alloy blended with one or more elements selected from Ti, Al, V, W, Ta, Si, Cr, and Ag, or Ag alone or a Ag-based alloy blended with one or more elements selected from Ti, Al, V, W, Ta, Si, Cr, and Cu.

A fifth aspect of the invention is
the method for producing a laminate film described in the fourth aspect, wherein
the layered film has a second metal absorption layer, which is a third layer as counted from the transparent substrate side, and
the method comprising:
forming the second metal absorption layer by using the reactive sputtering method described in the third aspect.

### EFFECTS OF THE INVENTION

According to the reactive sputtering method of the present invention for performing deposition by using a sputtering device including a magnetron sputtering cathode to which a sputtering target is mounted inside a vacuum chamber, and by introducing a process gas containing a reactive gas into the vacuum chamber, water is contained in the reactive gas, and the water is adsorbed in the surfaces of the above-described particle deposit and nodule in the ionized state or in the state of water molecules.

In addition, the particle deposit and the nodule are fixed to and unlikely to be peeled off from the sputtering target owing to the action of water adsorbed in the ionized state or in the state of water molecules, and further, the electric charges of the charged particle deposit and nodule are reduced by the electric conduction action of the water, so that arc discharge and the like are also suppressed. The present invention thus has advantageous effects that allow a high quality film without any adhesion of foreign matters to the deposition target or dents to be simply and easily formed.

### BRIEF DESCRIPTION OF THE DRAWINGS

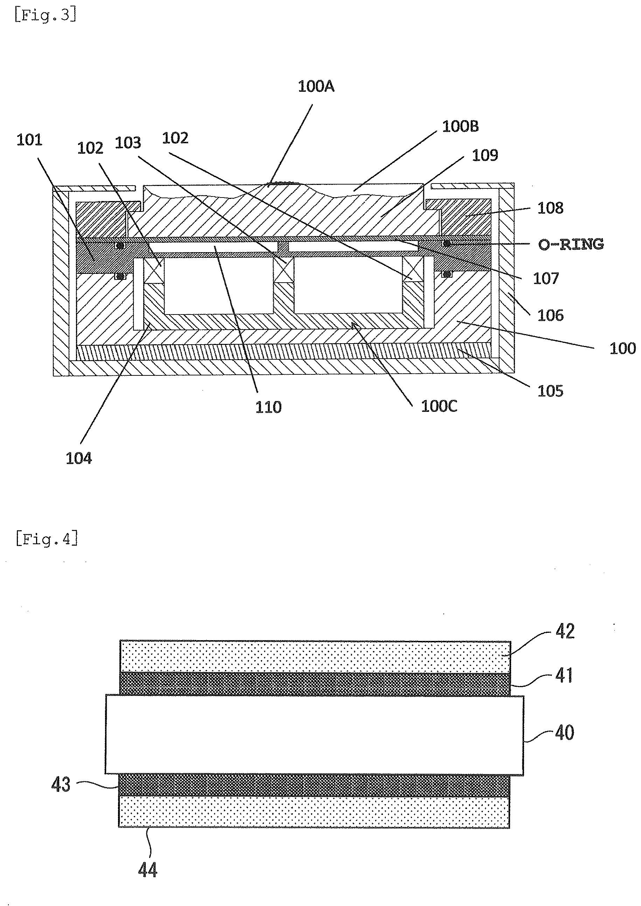

[Fig. 1] Fig. 1 is a configuration explanatory diagram of a sputtering device (sputtering web coater) including a magnetron sputtering cathode to which a sputtering target is mounted inside a vacuum chamber.
[Fig. 2] Fig. 2 is a partially enlarged diagram of the sputtering device (sputtering web coater) shown in Fig. 1.
[Fig. 3] Fig. 3 is a schematic cross-sectional explanatory diagram of the magnetron sputtering cathode to which the sputtering target has been mounted.
[Fig .4] Fig. 4 is a schematic cross-sectional explanatory diagram of a laminate film including a metal absorption layer (reactive sputtering deposition layer), which is the first layer as counted from the transparent substrate side, and a metal layer, which is the second layer, on each surface of a transparent substrate made of a resin film.

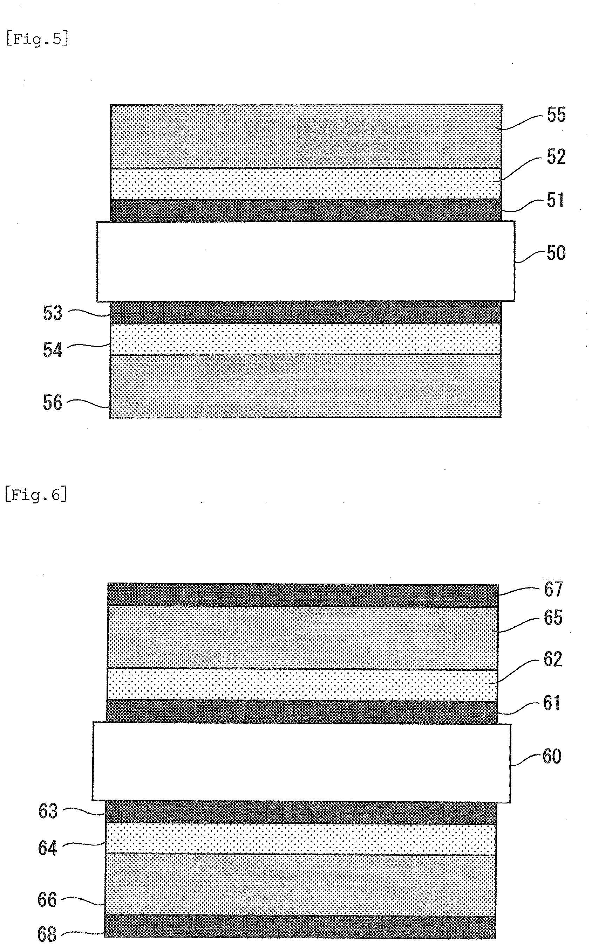

[Fig. 5] Fig. 5 is a schematic cross-sectional explanatory diagram of a laminate film including a metal absorption layer (reactive sputtering deposition layer), which is the first layer as counted from the transparent substrate side, and a metal layer, which is the second layer, on each surface of a transparent substrate made of a resin film, in which the metal layers are formed by a dry deposition method and a wet deposition method.
[Fig. 6] Fig. 6 is a schematic cross-sectional explanatory diagram of a laminate film including a metal absorption layer (reactive sputtering deposition layer), which is the first layer as counted from the transparent substrate side, a metal layer, which is the second layer, and a second metal absorption layer (second reactive sputtering deposition layer), which is the third layer, on each surface of a transparent substrate made of a resin film, in which the metal layers are formed by a dry deposition method and a wet deposition method.

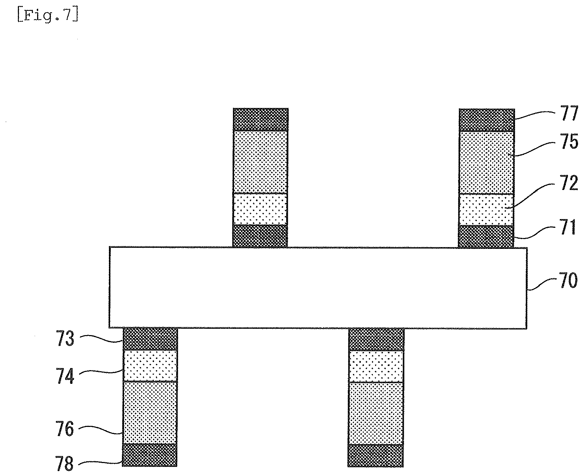

[Fig. 7] Fig. 7 is a schematic cross-sectional explanatory diagram of an electrode substrate film including a metal-made laminate thin line formed on each surface of a transparent substrate made of a resin film.

### MODES FOR PRACTICING THE INVENTION

Hereinafter, embodiments of the present invention are described in detail with reference to the drawings.

### (1) Sputtering Device Including Magnetron Sputtering Cathode

### (1-1) Sputtering Device (Sputtering Web Coater)

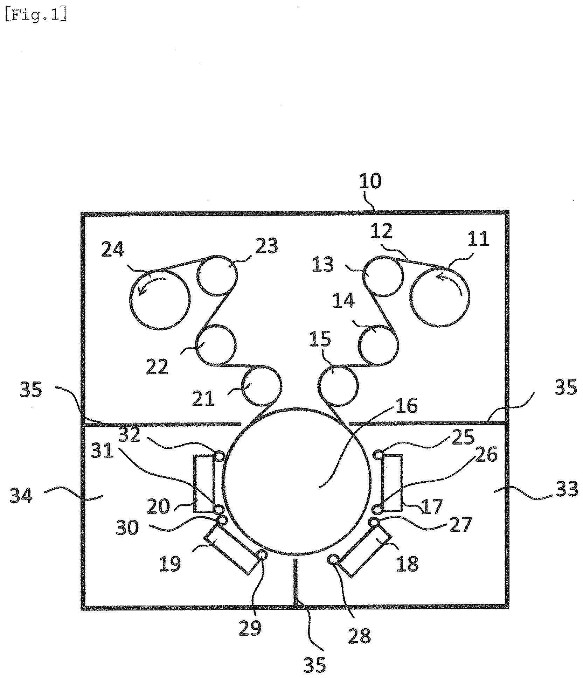

A sputtering device that continuously performs deposition on a long resin film being transported in a roll-to-roll system is called a sputtering web coater. Such sputtering web coater is provided in a vacuum chamber 10 as illustrated in Fig. 1, and configured such that after the sputtering web coater performs a predetermined deposition on a long resin film 12, which is unwound from an unwinding roll 11, the long resin film 12 is wound on a winding roll 24. In the course of a transport path including the unwinding roll 11 to the winding roll 24, a can roll 16, which is driven to rotate by a motor, is disposed. Inside the can roll 16, a coolant, whose temperature is regulated outside the vacuum chamber 10, is circulated.

In the vacuum chamber 10, a pressure reduction to an ultimate pressure of approximately 10⁻⁴ Pa, and the following pressure adjustment to approximately 0.1 to 10 Pa by introducing a process gas (sputtering gas) are conducted for sputtering deposition. A publicly known gas such as argon is used as the process gas, and a reactive gas such as oxygen is further added to the process gas. The shape and material of the vacuum chamber 10 are not particularly limited and any of various shapes and materials may be employed as long as the vacuum chamber 10 is durable in such a depressurized state. In addition, various devices (not shown) such as a dry pump, a turbomolecular pump, and a cryocoil (cryogenic coil) are incorporated in the vacuum chamber 10 to reduce the pressure inside the vacuum chamber 10 and maintain this state, and further the vacuum chamber 10 may be partitioned into deposition chambers 33 and 34 by a plurality of partition plates 35.

In a transport path from the unwinding roll 11 to the can roll 16, a free roll 13 that guides the long resin film 12 and a tension sensor roll 14 that measures the tension of the long resin film 12 are disposed in this order. In addition, the long resin film 12, which is sent out of the tension sensor roll 14 and transported toward the can roll 16, is adjusted relative to the peripheral speed of the can roll 16 by a motor-driven front feed roll 15 provided in a vicinity of the can roll 16. This makes it possible to bring the long resin film 12 into tight contact with the outer peripheral surface of the can roll 16.

In a transport path from the can roll 16 to the winding roll 24 as well, a motor-driven back feed roll 21 that adjusts the long resin film 12 relative to the peripheral speed of the can roll 16, a tension sensor roll 22 that measures the tension of the long resin film 12, and a free roll 23 that guides the long resin film 12 are disposed in this order in the same manner as described above.

In the unwinding roll 11 and the winding roll 24, the tension balance of the long resin film 12 is maintained through torque control performed by a powder clutch or the like. In addition, the long resin film 12 is unwound from the unwinding roll 11 and is wound on the winding roll 24 by the rotation of the can roll 16 as well as rotations of the motor-driven front feed roll 15 and the back feed roll 21 which are rotated in conjunction with the rotation of the can roll 16.

Near the can roll 16, magnetron sputtering cathodes 17, 18, 19 and 20 serving as deposition means, to which sputtering targets are respectively mounted, are incorporated at positions facing a transport path defined on the outer peripheral surface of the can roll 16 (i.e. a region where the long resin film 12 is wound within the outer peripheral surface of the can roll 16), and gas discharge pipes 25, 26, 27, 28, 29, 30, 31, and 32 that discharge the reactive gas are provided near the magnetron sputtering cathodes 17, 18, 19 and 20.

### (1-2) Reactive Sputtering Method

If an oxide or nitride target is employed for the purpose of forming a metal absorption layer (sometimes referred to as a reactive sputtering deposition layer) made of a metal oxide or a metal nitride, the deposition speed is too slow, so this approach is not suitable for mass production. For this reason, a reactive sputtering method has been employed which uses a Ni-based sputtering target capable of highspeed deposition and introduces a reactive gas made of oxygen, nitrogen, or the like under control.

Then, the following four methods have been known as methods for controlling a reactive gas.
(1-2-1) A method including discharging a reactive gas at a constant flow rate
(1-2-2) A method including discharging a reactive gas in such a manner as to maintain a constant pressure
(1-2-3) A method including discharging a reactive gas in such a manner as to make constant the impedance of a sputtering cathode (impedance control)
(1-2-4) A method including discharging a reactive gas in such a manner as to make constant the intensity of plasma for sputtering (plasma emission control)

### (2) Problems of Reactive Sputtering Method and Improvement Measure Taken by the Present Invention

### (2-1) Structure of Magnetron Sputtering Cathode

Fig. 3 is a schematic cross-sectional explanatory diagram of a magnetron sputtering cathode to which a sputtering target has been mounted. That is, the magnetron sputtering cathode has a structure including a magnetic circuit (magnetism generating mechanism) 100C in a housing formed by a housing body 100 and a housing cover 101, as shown in Fig. 3.

In addition, the magnetic circuit (magnetism generating mechanism) 100C includes a central magnetic pole 103 and optionally an intermediate magnetic pole (not shown) inside an outer peripheral magnetic pole 102 having a substantially rectangular shape or a long circular shape, where the central magnetic pole 103 is arranged substantially in parallel with a long side direction of the outer peripheral magnetic pole 102, and also includes a magnetic yoke 104 provided with these magnetic poles on a surface thereof.

A lower face of the housing body 100 is fixed to a earth shield (grounding shield) 106 via an insulating plate 105. A clamp 108 is provided on the housing cover 101 on the upper end side of the housing body 100 with a cooling plate 107 interposed in between. In addition, an O-ring is disposed between the housing body 100 and the housing cover 101 to maintain the air tightness in the magnetron sputtering cathode and also to contribute to an improvement in air tightness in a vacuum chamber of a sputtering device in which the magnetron sputtering cathode is disposed.

A sputtering target 109 is fixed to the surface of the cooling plate 107 by the clamp 108, and the housing body 100 and the sputtering target 109 are electrically insulated from the grounding shield 106. A cooling water channel 110 in which a cooling water is circulated is provided between the housing cover 101 and the cooling plate 107, and is adapted to cool down the sputtering target 109 during sputtering deposition. Note that an O-ring is also disposed between the housing cover 101 and the cooling plate 107 to prevent the cooling water from flowing into the vacuum chamber.

### (2-2) Generation of Particle Deposit

The process of generation of a particle deposit on a non-erosion region 100A of the sputtering target 109 during deposition by the reactive sputtering is as described below.

The magnetron sputtering cathode is disposed inside a vacuum chamber or a deposition chamber which is capable of maintaining a reduced-pressure atmosphere, such that the sputtering target 109 faces a deposition target. When deposition is performed, the pressure inside the vacuum chamber in which the sputtering target 109 and the deposition target have been disposed is reduced and an Ar gas serving as a process gas is introduced into the vacuum chamber. Applying a voltage to the sputtering target 109 in this state allows the Ar gas to be ionized with electrons emitted from the sputtering target 109, and the ionized Ar gas collides with and sputter the surface of the sputtering target 109 to force out sputtering particles from the sputtering target 109. These sputtering particles are eventually deposited and forms a thin film on the surface of the deposition target.

In this event, a poloidal magnetic field is generated on the surface of the sputtering target 109, so that a voltage of minus several hundred volts is normally applied to the sputtering target 109, but its periphery is maintained at the earth potential (ground potential). This potential difference causes a crossed electromagnetic field to be generated on the surface of the sputtering target 109. Secondary electrons emitted from the surface of the sputtering target 109 make motion drawing a cycloidal path in a direction perpendicular to the crossed electromagnetic field on the surface of the sputtering target 109. Electrons which have collided with the Ar gas and lost part of their energy during the motion make a trochoidal motion inside the crossed electromagnetic field and move, while drifting, inside the poloidal magnetic field.

During this event, the electrons collide again with the Ar gas to generate Ar ions and electrons due to the α action expressed by Ar + e⁻ → Ar⁺ + 2e⁻. Once scattered in the sheath region, the generated Ar ions are abruptly accelerated toward the negatively applied sputtering target 109. When the Ar ions having a kinetic energy of several hundred eV collide with the sputtering target 109, the sputtering target 109 is subjected to sputtering, so that sputtering particles are emitted from the sputtering target 109 and secondary electrons are emitted therefrom due to the γ action. The above-described phenomena occur like an avalanche, so that the plasma is maintained.

Electrons moving while drawing a trochoidal path due to the magnetic circuit (magnetism generating mechanism) 100C and the electric field in the sputtering cathode are focused on a portion where the lines of magnetic force are parallel with the surface of the sputtering target 109, that is, at a location where the lines of magnetic force and the electric field are orthogonal to each other. The focusing of electrons causes the collision of the electrons with the Ar gas to frequently occur, causing the forcing out of the target substance by the ionized Ar gas to be focused. As a result, an erosion 100B is generated at a specific location on the sputtering target 109 as shown in Fig. 3.

In the sputtering deposition, the target substance that has been forced out not only covers the deposition target but also adheres to the non-erosion region 100A of the sputtering target 109, forming a particle deposit. Moreover, in the reactive sputtering, such a particle deposit is an oxide or a nitride of the target substance generated by the reaction of the target substance with the reactive gas, is unlikely to be eroded by the Ar ions generated by plasma, and is thus deposited on the non-erosion region 100A.

Then, the particle deposit is eventually peeled off from the sputtering target during the sputtering deposition, and adheres to the deposition target or causes the arc discharge.

### (2-3) Generation of Nodule

In addition, during the sputtering deposition, a foreign matter called a nodule is sometimes generated on a portion of the erosion 100B (the portion subjected to the sputtering in the target) besides the particle deposit. The nodule is likely to be generated at a location on an end of the portion where the erosion 100B is generated in the sputtering target 109. At the location where the nodule is likely to be generated, the sputtering with the Ar ions is weak, and accordingly, the sputtering partially progresses, while an oxide or a nitride remains in a portion where the sputtering has not progressed. The oxide or nitride at the location where the nodule has been generated is in the form of protrusions. In addition, such oxide or nitride is electrically charged because of its electrical insulating properties. Thus, the oxide or nitride is eventually discharged and the protrusions are also scattered to adhere the surface of the deposition target.

The discharge caused by the particle deposit and the nodule on the non-erosion region 100A causes dents to be formed on the surface of the deposition target, and if the particle deposit and the nodule adhere to the surface of the deposition target, this possibly leads to protrusions and the like.

The generation of these particle deposit and nodule as well as defects such as arc discharge attributable thereto are phenomena observed in the reactive sputtering. The particle deposit and the nodule are not generated when no reactive gas is added to the sputtering atmosphere.

### (2-4) Improvement Measure by the Present Invention

When water is added to the sputtering atmosphere in addition to a reactive gas such as an oxygen gas or a nitrogen gas, the generation of arc discharge is suppressed and the peeling of a particle deposit from the sputtering target can be suppressed, as described above. When water is added to the sputtering atmosphere, part of the water is decomposed into ions in plasma while the remaining part of the water is adsorbed, in the state of water molecules, to the surfaces of the particle deposit and the nodule. Further, part of ions of water molecules decomposed in the plasma is also adsorbed to the particle deposit and the nodule.

It is considered that when a particle deposit or a nodule have adsorbed water molecules or ions generated from the water molecules, the electric charge of the charged particle deposit or nodule decreases, allowing arc discharge and the like to be suppressed, and the water molecules and the like thus adsorbed fix the particle deposit or nodule to the sputtering cathode(sputtering target), making it unlikely for the particle deposit or nodule to be peeled off from the sputtering cathode(sputtering target), and thus making it unlikely for a foreign matter to adhere to the surface of the deposition target.

Then, the reactive sputtering method according to the present invention in which water is added to a reactive gas makes it possible to avoid arc discharge and the like by suppressing the charging of a particle deposit or nodule without making any large-scale modification on the position to attach a gas discharge pipe for supplying a reactive gas to a sputtering atmosphere, and the like, and further has significant advantageous effects that allow a high quality film to be simply and easily formed because a foreign matter becomes unlikely to adhere to the surface of the deposition target.

Here, a proportion of water to be added in a process gas, which is introduced into a vacuum chamber, is preferably 0.25 % by volume or more, and desirably within a range of 0.25 % by volume or more and 12.5 % by volume or less, of the process gas (for example, an Ar gas) to be introduced into the vacuum chamber.

If the proportion of water to be added is less than 0.25 % by volume, it sometimes becomes impossible to suppress the discharging attributable to the particle deposit and the nodule and to sufficiently suppress adhesion of a foreign matter to the surface of the deposition target. On the other hand, if the proportion of water to be added is more than 12.5 % by volume, the chemical and physical properties of a film (thin film) formed by the reactive sputtering change, sometimes making it difficult to form a desired film (thin film). Further, when deposition is performed under a condition that the proportion of water to be added is more than 12.5 % by volume, it is necessary to adjust the proportion of the reactive gas such as an oxygen gas as appropriate, in order to form a film such that the chemical and physical properties of the film obtained by the sputtering deposition are not different from those of a film formed under a condition that water is not added. As a result, it becomes difficult to control the quality of a film in some cases.

Note that since the pressure of the process gas (for example, an Ar gas) in the vacuum chamber varies depending on the shape of the vacuum chamber and the position where a pressure gauge is disposed, the pressure may be determined individually in accordance with the sputtering device to be applied. In general, the total pressure of the sputtering atmosphere in the vacuum chamber at the time of sputtering deposition is 0.1 to 10 Pa, and desirably 0.1 Pa to 1 Pa. The partial pressures of the process gas (for example, an Ar gas), the reactive gas, and water may be adjusted as appropriate to meet the range of the total pressure within the scope of the present invention.

### (3) Laminate Film

A first laminate film produced by employing the reactive sputtering method according to the present invention includes: a transparent substrate made of a resin film; and a layered film provided on at least one surface of the transparent substrate, in which the layered film includes: a metal absorption layer (reactive sputtering deposition layer), which is the first layer as counted from the transparent substrate side; and a metal layer, which is the second layer, and the metal absorption layer (reactive sputtering deposition layer) is formed by a reactive sputtering method that uses a sputtering target made of Ni alone or a Ni-based alloy blended with one or more elements selected from Ti, Al, V, W, Ta, Si, Cr, Ag, Mo, and Cu, and a reactive gas (reactive gas made of at least one of an oxygen gas and a nitrogen gas) containing water. In addition, a second laminate film is based on the first laminate film, in which the layered film includes a second metal absorption layer (second reactive sputtering deposition layer), which is the third layer as counted from the transparent substrate side, and the second metal absorption layer (second reactive sputtering deposition layer) is formed by a reactive sputtering method that uses a sputtering target made of Ni alone or a Ni-based alloy blended with one or more elements selected from Ti, Al, V, W, Ta, Si, Cr, Ag, Mo, and Cu, and a reactive gas (reactive gas made of at least one of an oxygen gas and a nitrogen gas) containing water.

### (3-1) First Laminate Film

As shown in Fig. 4, an exemplary structure of the first laminate film is a structure including: a transparent substrate 40 made of a resin film; metal absorption layers (reactive sputtering deposition layers) 41 and 43 formed on both surfaces of the transparent substrate 40 by a dry deposition method (dry plating method); and metal layers 42 and 44.

Note that the above-described metal layers may be formed by a combination of a dry deposition method (dry plating method) and a wet deposition method (wet plating method).

Specifically, as shown in Fig. 5, the structure may include: a transparent substrate 50 made of a resin film; metal absorption layers (reactive sputtering deposition layers) 51 and 53 formed on both surfaces of the transparent substrate 50 by a dry deposition method (dry plating method) and each having a film thickness of 15 nm to 30 nm; metal layers 52 and 54 formed on the metal absorption layers (reactive sputtering deposition layers) 51 and 53 by a dry deposition method (dry plating method); and metal layers 55 and 56 formed on the metal layers 52 and 54 by a wet deposition method (wet plating method) is possible.

### (3-2) Second Laminate Film

Next, a second laminate film is based on the first laminate film shown in Fig. 5, and is produced by forming a second metal absorption layer (second reactive sputtering deposition layer) on the metal layer of the laminate film.

Specifically, as shown in Fig. 6, an exemplary structure is a structure including: a transparent substrate 60 made of a resin film; metal absorption layers (reactive sputtering deposition layers) 61 and 63 formed on both surfaces of the transparent substrate 60 by a dry deposition method (dry plating method) and each having a film thickness of 15 nm to 30 nm; metal layers 62 and 64 formed on the metal absorption layers (reactive sputtering deposition layers) 61 and 63 by a dry deposition method (dry plating method); metal layers 65 and 66 formed on the metal layers 62 and 64 by a wet deposition method (wet plating method); and second metal absorption layers (second reactive sputtering deposition layers) 67 and 68 formed on the metal layers 65 and 66 by a dry deposition method (dry plating method) and each having a film thickness of 15 nm to 30 nm.

Here, in the second laminate film shown in Fig. 6, the metal absorption layer (reactive sputtering deposition layer) 61 and the second metal absorption layer (second reactive sputtering deposition layer) 67 are formed on both surfaces of the metal layers denoted by reference signs 62 and 65 and the metal absorption layer (reactive sputtering deposition layer) 63 and the second metal absorption layer (second reactive sputtering deposition layer) 68 are formed on both surfaces of the metal layers denoted by reference signs 64 and 66 so that a circuit pattern made of a metal laminate thin line and having a mesh structure should not be visible by reflection when an electrode substrate film fabricated using the laminate film is incorporated in a touch panel.

Note that it is also possible to prevent the circuit pattern from being visually recognized through the transparent substrate by fabricating an electrode substrate film using a first laminate film in which a metal absorption layer (reactive sputtering deposition layer) is formed on one surface of the transparent substrate made of a resin film and a metal layer is formed on the metal absorption layer (reactive sputtering deposition layer).

### (3-3) Sputtering Target Material For Metal Absorption Layer and Second Metal Absorption Layer

In a laminate film according to the present invention, which is to be processed into an electrode substrate film for a "touch panel", as the sputtering target for the metal absorption layer (reactive sputtering deposition layer) and the second metal absorption layer (second reactive sputtering deposition layer), a target material containing Ni alone or a Ni-based alloy blended with one or more elements selected from Ti, Al, V, W, Ta, Si, Cr, Ag, Mo, and Cu is used, and a Ni-Cu alloy is preferable as the Ni-based alloy.

Here, for the metal absorption layer and the second metal absorption layer of the laminate film according to the present invention, as the sputtering target, a sputtering target material made of Ni alone or a Ni-based alloy blended with one or more elements selected from Ti, Al, V, W, Ta, Si, Cr, Ag, Mo, and Cu described above is specified.

However, for a reactive sputtering deposition layer for which the laminate film according to the present invention is not intended, the sputtering target material is not limited to the above-described one. Specifically, a reactive sputtering deposition layer that is formed by a reactive sputtering method that employs a sputtering target other than Ni alone or a Ni-based alloy blended with one or more elements selected from Ti, Al, V, W, Ta, Si, Cr, Ag, Mo, and Cu described above and a reactive gas (reactive gas made of at least one of an oxygen gas and a nitrogen gas) containing water is also encompassed by the deposition layer of the reactive sputtering method according to the present invention. For example, the case where a film of tin-doped indium oxide (ITO) is formed by reactive sputtering is also encompassed by the deposition layer of the reactive sputtering method according to the present invention.

### (3-4) Constituent Material of Metal Layer in Laminate Film

The constituent material of the metal layer in the laminate film according to the present invention is not particularly limited as long as the material is a metal having a low electrical resistance value, and may be, for example, Cu alone or a Cu-based alloy blended with one or more elements selected from Ti, Al, V, W, Ta, Si, Cr, and Ag, or Ag alone or a Ag-based alloy blended with one or more elements selected from Ti, Al, V, W, Ta, Si, Cr, and Cu, and Cu alone is desirably used from the viewpoints of the processability into a circuit pattern and the resistance value.

### (3-5) Constituent Material of Transparent Substrate in Laminate Film

The constituent material of the transparent substrate in the laminate film according to the present invention is not particularly limited, and may be, for example, a resin film made of one resin material selected from polyethylene terephthalate (PET), polyethersulfone (PES), polyallylate (PAR), polycarbonate (PC), polyolefin (PO), triacetylcellulose (TAC), and norbornene, or a complex including a resin film made of one resin material selected from the above-described resin materials and an acrylic organic film covering one or both surfaces of the resin film. Particularly, the norbornene resin material includes Zeonor (trade name) available from Zeon Corporation, Arton (trade name) available from JSR Corporation, and the like as exemplary examples.

Note that since the electrode substrate film fabricated using the laminate film according to the present invention is for use in a "touch panel" or the like, a resin film excellent in transparency in the visible wavelength region is desirable among the above-described resin films.

### (4) Electrode Substrate Film

(4-1) To manufacture a "sensor panel" having a metal mesh disclosed in Patent Document 2 from the above-described laminate film (for example, the second laminate film), the layered film in the second laminate film, that is, the layered film including the metal absorption layer (reactive sputtering deposition layer), the metal layer, and the second metal absorption layer (second reactive sputtering deposition layer) only have to be processed into a laminate thin line having a line width of 20 µm or less. Note that the "sensor panel" having a metal mesh disclosed in Patent Document 2 will be called an electrode substrate film. To be specific, an electrode substrate film as shown in Fig. 7 can be obtained by subjecting the layered film in the second laminate film shown in Fig. 6 to an etching process.

Specifically, an electrode substrate film as shown in Fig. 7 includes: a transparent substrate 70 made of a resin film; and a circuit pattern having a mesh structure including a metal-made laminate thin line provided on both surfaces of the transparent substrate 70, in which the metal-made laminate thin line includes: metal absorption layers (reactive sputtering deposition layers) 71 and 73 each of which has a line width of 20 µm or less and is the first layer as counted from the transparent substrate 70 side; metal layers 72, 75, 74, and 76 each of which is the second layer; and second metal absorption layers (second reactive sputtering deposition layers) 77 and 78 each of which is the third layer.

Then, forming the electrode (wiring) pattern of the electrode substrate film into a stripe shape or a lattice shape for a touch panel allows the electrode substrate film to be used in a touch panel. In addition, since the metal-made laminate thin line processed to have an electrode (wiring) pattern maintains the laminate structure of the laminate film, the electrode substrate film can be provided as an electrode substrate film in which a circuit pattern such as an electrode provided on the transparent substrate is quite unlikely to be visually recognized even under high intensity illumination.

(4-2) Then, it is possible to process the laminate film according to the present invention into an electrode substrate film with a wiring pattern by using a publicly known subtractive method.

The subtractive method includes: forming a photoresist film on a layered film surface of a laminate film; performing exposure and development such that the photoresist film remains at a location where a wiring pattern is to be formed, and removing the layered film at a location where the photoresist film is not present on the layered film surface by chemical etching.

As the etching solution for the chemical etching, a ferric chloride solution or a cupric chloride solution may be used.

### EXAMPLES

Hereinafter, Examples of the present invention are specifically described by giving Comparative Example. The present invention is however not limited to Examples described below.

### [Examples 1 to 6]

The sputtering device (sputtering web coater) shown in Fig. 1 in which the inside of the vacuum chamber 10 is partitioned by the partition plate 35 into the deposition chambers 33 and 34 was used. An oxygen gas was used as the reactive gas, and the can roll 16 was made of stainless steel with a diameter of 600 mm and a width of 750 mm, and provided with hard chrome plating on its roll body surface. The front feed roll 15 and the back feed roll 21 are made of stainless steel with a diameter of 150 mm and a width of 750 mm, and provided with hard chrome plating on their roll body surfaces. In addition, the gas discharge pipes 25, 26, 27, 28, 29, 30, 31, and 32 are provided upstream and downstream of the respective magnetron sputtering cathodes 17, 18, 19, and 20, and a Ni-Cu target for the metal absorption layer (reactive sputtering deposition layer) is mounted to the magnetron sputtering cathodes 17 and 18 and a Cu target for the metal layer is mounted to the magnetron sputtering cathodes 19 and 20.

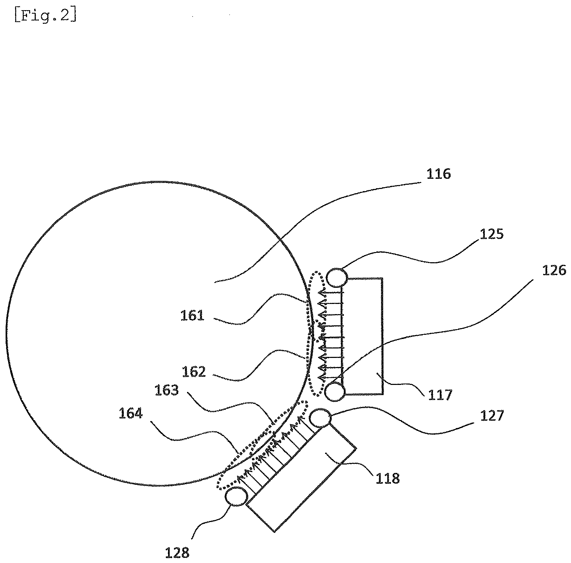

Note that the magnetron sputtering cathodes 17 and 18 in Fig. 1 correspond to magnetron sputtering cathodes 117 and 118 in Fig. 2, and the gas discharge pipes 25, 26, 27, and 28 in Fig. 1 correspond to gas discharge pipes 125, 126, 127, and 128 in Fig. 2.

As the long resin film 12 constituting the transparent substrate, a PET film having a width of 600 mm and a length of 1200 m was used, and the can roll 16 was cooled down and controlled to 0°C. In addition, the vacuum chamber 10 and the deposition chambers 33 and 34 were exhausted to 5 Pa by using a plurality of dry pumps, and were further exhausted to 1 × 10⁻⁴ Pa by using pluralities of turbomolecular pumps and cryocoil.

The argon gas introduced into the vacuum chamber 10 was a dry argon gas which was not passed through water unless otherwise specified, and was not a bubbling argon gas which was passed through water.

Then, the transport speed of the long resin film 12 was set to 2 m/min, and thereafter, the argon gas was introduced at 300 sccm from the gas discharge pipes 29, 30, 31, and 32, and deposition was performed on the cathodes 19 and 20 with such electric power control that a Cu film thickness of 80 nm was obtained. On the other hand, a mixture gas obtained by mixing 280 sccm of a bubbling argon gas, which was passed through water, and an argon gas in total as well as 15 sccm of an oxygen gas was introduced into the vacuum chamber 10 from the gas discharge pipes 25, 26, 27, and 28 shown in Fig. 1 (or the gas discharge pipes 125, 126, 127, and 128 in Fig. 2), and deposition was performed on the cathodes 17 and 18 shown in Fig. 1 (or the magnetron sputtering cathodes 117 and 118 in Fig. 2) with such electric power control that a Ni-Cu oxide film thickness of 30 nm was obtained, while the water partial pressure was controlled by means of a mixing ratio of the bubbling argon gas and the argon gas, and the total pressure of the deposition chambers 33 and 34 was adjusted to be 0.4 Pa by means of the supply and exhaust of the gas.

Then, the proportions of water added according to Examples 1 to 6 to be contained in a sputtering atmosphere in the deposition chamber 33 are shown in Table 1-1 and Table 1-2 below. Note that it is expected that the deposition speed on the metal absorption layer (reactive sputtering deposition layer) would become lower depending on the amounts of water and oxygen to be introduced from the gas discharge pipes. For this reason, it is necessary to adjust the electric power for the sputtering in order to obtain a target film thickness of the metal absorption layer (reactive sputtering deposition layer). In addition, the magnetron sputtering cathode 117 and the magnetron sputtering cathode 118 in the sputtering device (the sputtering web coater) employed in Examples and the like are not differentially pumped, and the gas atmospheres 161, 162, 163, and 164 shown in Fig. 2 are not independent from each other.

Then, laminate films according to Examples 1 to 6, each including a transparent substrate made of a long PET film; and a layered film including a Ni-Cu metal absorption layer (reactive sputtering deposition layer) and a Cu metal layer provided on the transparent substrate were produced.

### [Comparative Example 1]

A laminate film was produced substantially in the same manner as that for Example 1 except that a reactive gas that contains almost no water (the proportion of water added was 0.1 % by volume or less) was used.

Specifically, a laminate film according to Comparative Example 1, including: a transparent substrate made of a long PET film; and a layered film including a Ni-Cu metal absorption layer (reactive sputtering deposition layer) and a Cu metal layer provided on the transparent substrate was produced substantially in the same manner as that for Example 1 except that almost no water was introduced from the gas discharge pipes 125 and 126 of the magnetron sputtering cathode 117 and the gas discharge pipes 127 and 128 of the magnetron sputtering cathode 118.

### [Evaluation Test]

(1) Each of the laminate films (a laminate film including a layered film including: a reactive sputtering deposition layer, which is the first layer as counted from the transparent substrate side; and a Cu layer, which is the second layer) according to Examples 1 to 6 and Comparative Example 1 was sampled at a position displaced by 100 m and a position displaced by 500 m after the start of deposition. An observation of the appearance of each laminate film (the number of foreign matters each having a size of 20 µm or larger and being present per m² of the film) and an electrical current test after a 40 µm-pitch wiring process (a wiring width of 20 µm and a wiring pitch of 20 µm) were performed.
(2) The wiring process on the laminate film was achieved by performing chemical etching on the layered film(the reactive sputtering deposition layer and the Cu layer) using a ferric chloride solution as an etching solution.
(3) Results of evaluation are shown in Table 1-1 and Table 1-2 below.

**[Table 1-1]**

| | | 100 m | |
|---|---|---|---|
| | Proportion of Water Added | Foreign Matters (20 µm or more) | Electric Current Test on 40 µm-pitch Wiring |
| | | pieces/m² | The Number of Passes/The Number of Tests |
| Example 1 | 1.25 % by volume | 10 | 5/5 |
| Example 2 | 2.5 % by volume | 8 | 5/5 |
| Example 3 | 0.25 % by volume | 23 | 5/5 |
| Example 4 | 5 % by volume | 9 | 5/5 |
| Example 5 | 12.5 % by volume | 5 | 5/5 |
| Example 6 | 25 % by volume | 6 | 0/5 |
| Comparative Example 1 | 0.1 % by volume or less | 68 | 2/5 |

**[Table 1-2]**

| | | 500 m | |
|---|---|---|---|
| | Proportion of Water Added | Foreign Matters (20 µm or more) | Electric Current Test on 40 umpitch Wiring |
| | | pieces/m² | The Number of Passes/The Number of Tests |
| Example 1 | 1.25 % by volume | 12 | 5/5 |
| Example 2 | 2.5 % by volume | 8 | 5/5 |
| Example 3 | 0.25 % by volume | 25 | 5/5 |
| Example 4 | 5 % by volume | 7 | 5/5 |
| Example 5 | 12.5 % by volume | 6 | 5/5 |
| Example 6 | 25 % by volume | 4 | 0/5 |
| Comparative Example 1 | 0.1 % by volume or less | 125 | 1/5 |

### [Confirmation]

(1) From the observation of the appearances (the number of foreign matters each having a size of 20 µm or larger and being present per m² of the film) of Example 3, which contained 0.25 % by volume of water in the sputtering atmosphere (the proportion of water added was the smallest among Examples 1 to 6), and Comparative Example 1, which contained almost no water in the sputtering atmosphere (the proportion of water added was 0.1 % by volume or less), it was confirmed that the number of foreign matters was significantly reduced even in Example 3, in which the proportion of water to be added was the smallest among Examples 1 to 6 (the number of foreign matters was 23 pieces/m² and 25 pieces/m² in the laminate film respectively at 100-m and 500-m positions), as compared with Comparative Example 1 (the number of foreign matters was 68 pieces/m² and 125 pieces/m² in the laminate film respectively at 100-m and 500-m positions).
   That is, it was confirmed that the action of the water contained in the reactive gas made it unlikely for a particle deposit and a nodule to be peeled off from the sputtering target, and also reduced the electric charge of the charged particle deposit or nodule, allowing arc discharge and the like to be suppressed.
(2) In addition, when the observation of the appearance (the number of foreign matters each having a size of 20 µm or larger and being present per m² of the film) of Example 6, which contained 25 % by volume of water in the sputtering atmosphere (the proportion of water added was the largest among Examples) was compared with those of the other Examples. According to this, it was confirmed that there was no difference in the number of foreign matters between Example 6 (the number of foreign matters was 6 pieces/m² and 4 pieces/m² in the laminate film respectively at 100-m and 500-m positions) and the other Examples (the number of foreign matters was 5 pieces/m² to 23 pieces/m² and 6 pieces/m² to 25 pieces/m² in the laminate film respectively at 100-m and 500-m positions).
(3) However, when the wiring processability (etchability) was evaluated, it was confirmed that Example 6 was slightly poor in wiring processability.

It is considered that this is because deposition was performed in a state where a large amount of water (25 % by volume) was contained in the sputtering atmosphere in Example 6, making the chemical behavior of the reactive sputtering deposition layer significantly different as a consequence, so that difference occurred in wiring processability (etchability) from the other Examples.

Nevertheless, it is possible to overcome the above-described problem of Example 6 regarding the wiring processability by appropriately selecting an etching solution suitable for the reactive sputtering deposition layer of Example 6.

### POSSIBILITY OF INDUSTRIAL APPLICATION

The reactive sputtering method according to the present invention makes it possible to simply and easily form a high quality film without adhesion of any foreign matters to a deposition target or formation of a dent, and thus has a possibility of industrial application for use in the production of a laminate film for electrode substrates to be incorporated in a "touch panel", which is mounted in a surface of a FPD (flat panel display).

### REFERENCE SIGNS LIST

1
10 vacuum chamber
11 unwinding roll
12 long resin film
13 free roll
14 tension sensor roll
15 front feed roll
16 can roll
17 magnetron sputtering cathode
18 magnetron sputtering cathode
19 magnetron sputtering cathode
20 magnetron sputtering cathode
21 back feed roll
22 tension sensor roll
23 free roll
24 winding roll
25 gas discharge pipe
26 gas discharge pipe
27 gas discharge pipe
28 gas discharge pipe
29 gas discharge pipe
30 gas discharge pipe
31 gas discharge pipe
32 gas discharge pipe
33 deposition chamber
34 deposition chamber
35 partition plate
40 resin film (transparent substrate)
41 metal absorption layer (reactive sputtering deposition layer)
42 metal layer (copper layer)
43 metal absorption layer (reactive sputtering deposition layer)
44 metal layer (copper layer)
50 resin film (transparent substrate)
51 metal absorption layer (reactive sputtering deposition layer)
52 metal layer formed by dry deposition method (copper layer)
53 metal absorption layer (reactive sputtering deposition layer)
54 metal layer formed by dry deposition method (copper layer)
55 metal layer formed by wet deposition method (copper layer)
56 metal layer formed by wet deposition method (copper layer)
60 resin film (transparent substrate)
61 metal absorption layer (reactive sputtering deposition layer)
62 metal layer formed by dry deposition method (copper layer)
63 metal absorption layer (reactive sputtering deposition layer)
64 metal layer formed by dry deposition method (copper layer)
65 metal layer formed by wet deposition method (copper layer)
66 metal layer formed by wet deposition method (copper layer)
67 second metal absorption layer (second reactive sputtering deposition layer)
68 second metal absorption layer (second reactive sputtering deposition layer)
70 resin film (transparent substrate)
71 metal absorption layer (reactive sputtering deposition layer)
72 metal layer formed by dry deposition method (copper layer)
73 metal absorption layer (reactive sputtering deposition layer)
74 metal layer formed by dry deposition method (copper layer)
75 metal layer formed by wet deposition method (copper layer)
76 metal layer formed by wet deposition method (copper layer)
77 second metal absorption layer (second reactive sputtering deposition layer)
78 second metal absorption layer (second reactive sputtering deposition layer)
100 housing body
101 housing cover
102 outer peripheral magnetic pole
103 central magnetic pole
104 magnetic yoke
105 insulating plate
106 earth shield (grounding shield)
107 cooling plate
108 clamp
109 sputtering target
110 cooling water channel
116 can roll
117 magnetron sputtering cathode
118 magnetron sputtering cathode
125 gas discharge pipe
126 gas discharge pipe
127 gas discharge pipe
128 gas discharge pipe
161 gas atmosphere
162 gas atmosphere
163 gas atmosphere
164 gas atmosphere
100A non-erosion region
100B erosion
100C magnetism generating mechanism (magnetic circuit)

## Claims

1. A reactive sputtering method for performing deposition by using a sputtering device including a magnetron sputtering cathode to which a sputtering target is mounted inside a vacuum chamber, and by introducing a process gas containing a reactive gas into the vacuum chamber, wherein
the reactive gas includes at least one of an oxygen gas and a nitrogen gas, and
water is contained in the reactive gas.

2. The reactive sputtering method according to claim 1, wherein a proportion of water added in the process gas to be introduced into the vacuum chamber is 0.25 % by volume or more and 12.5 % by volume or less.

3. The reactive sputtering method according to claim 1, wherein the sputtering target is made of Ni alone or a Ni-based alloy blended with one or more elements selected from Ti, Al, V, W, Ta, Si, Cr, Ag, Mo, and Cu.

4. A method for producing a laminate film, the laminate film including: a transparent substrate made of a resin film; and a layered film provided on at least one surface of the transparent substrate, the layered film having a metal absorption layer, which is a first layer as counted from the transparent substrate side, and a metal layer, which is a second layer as counted from the transparent substrate side, wherein
the method comprising:
forming the metal absorption layer by using the reactive sputtering method according to claim 3; and
forming the metal layer by using a sputtering device including a magnetron sputtering cathode to which a sputtering target is mounted inside a vacuum chamber, and by introducing a process gas containing no reactive gas into the vacuum chamber, the sputtering target made of Cu alone or a Cu-based alloy blended with one or more elements selected from Ti, Al, V, W, Ta, Si, Cr, and Ag, or Ag alone or a Ag-based alloy blended with one or more elements selected from Ti, Al, V, W, Ta, Si, Cr, and Cu.

5. The method for producing a laminate film according to claim 4, wherein
the layered film has a second metal absorption layer, which is a third layer as counted from the transparent substrate side, and
the method comprising:
forming the second metal absorption layer by using the reactive sputtering method according to claim 3.
